(19) **Europäisches Patentamt**

**European Patent Office**

**Office européen des brevets**

(11) Veröffentlichungsnummer : **0 343 377 B1**

(12) **EUROPÄISCHE PATENTSCHRIFT**

(45) Veröffentlichungstag der Patentschrift :
27.03.91 Patentblatt 91/13

(51) Int. Cl.⁵ : **H05K 3/22**

(21) Anmeldenummer : **89107073.2**

(22) Anmeldetag : **19.04.89**

(54) **Verfahren zur Herstellung von Formteilnutzen mit Formteilen zur Reparatur von Leiterbahnen und Vorrichtung zur Durchführung des Verfahrens.**

(30) Priorität : 26.05.88 DE 3817901

(43) Veröffentlichungstag der Anmeldung :
29.11.89 Patentblatt 89/48

(45) Bekanntmachung des Hinweises auf die
Patenterteilung :
27.03.91 Patentblatt 91/13

(84) Benannte Vertragsstaaten :
AT BE CH DE FR GB IT LI NL

(56) Entgegenhaltungen :
EP-A- 0 043 586
DE-A- 2 739 077
IBM TECHNICAL DISCLOSURE BULLETIN,
Band 14, Nr. 10, März 1972, Seite 2915, New
York, US; F.M. TAPPEN: "Open conductor repair for glass metal module"

(73) Patentinhaber : Siemens Aktiengesellschaft
Wittelsbacherplatz 2
W-8000 München 2 (DE)

(72) Erfinder : Dederer, Günther, Dipl.-Ing. (FH)
Wotanstrasse 12
W-8034 Germering (DE)

EP 0 343 377 B1

## Beschreibung

Die Erfindung betrifft ein Verfahren zur Herstellung von Formteilnutzen mit mindestens einem Formteil zur Reparatur von Leiterbahnen, insbesondere zur Reparatur von mäanderförmigen, trapezartigen Leiterbahnzügen mittels hartlotplattierter Formteile, deren Breite im Bereich von beispielsweise 50 bis 70 µm liegt. Formteile dieser Größenordnung besitzen meist eine Gesamtdicke von ca. 20 bis 30 µm.

Die Reparatur von Leiterbahnen wird mittels zur Leiterbahnunterbrechung deckungsgleicher Formteile durchgeführt. Zur Vereinfachung des Reparaturverfahrens werden sogenannte Formteilnutzen hergestellt, in denen eine Vielzahl von Formteilen mit allen möglichen Konfigurationen einer Leiterbahn enthalten sind. Ein derartiges Formteil wird auf seine Deckungsgleichheit ausgesucht und entsprechend symmetrisch zur Unterbrechung aus dem Formteilnutzen herausgestanzt. Die anschließende Reparatur erfolgt in einem weiteren unabhängigen Verfahren.

In der DE-PS 22 51 997 wird ein Verfahren beschrieben, das sich im wesentlichen auf die Materialeigenschaften eines Feinbandes und dessen Beschichtung mit allen Parametern der Hartlötung zur Reparatur der Leiterbahn bezieht. Die hier betrachteten Leiterbahnen haben eine Breite von 100 bis 150 µm und eine Höhe von ca. 50 µm. Der wesentliche Unterschied zu der Leiterbahngeneration die heute zu handhaben ist besteht in der Halbierung der Leiterbahnbreite und in der Ausgestaltung in Form von mäanderförmigen Strukturen. Bisher bekannte Stanzverfahren, die auf dem Positivstanzprinzip beruhen, das heißt deren Stempel die gleiche Breite und Kontur des herauszustanzenden Formteils besitzen, stossen bei der beschriebenen Dimensionierung, bei der ein Stempel beispielsweise 60 µm Breite haben müßte, an ihre Grenzen. Derartige Stempel sind den Belastungen beim Stanzen von Kupferbändern oder hartlotplattierten Kupferbändern nicht gewachsen und brechen.

Aus DE-A-2739077 ist ferner ein Verfahren zum vor einem Biege oder Zichvorgang vorzunehmenden Stanzen aus einem schrittweise unter einem Satz Stauzwerkzeuge fortschreitenden Blechstreifen bekannt. Die Bewegung des Blechstreifen erfolgt mit einem Vorschubschritt, der praktisch gleich der Längsabmessung eines Stanzteils ist.

Der Erfindung liegt die Aufgabe zugrunde, ein Verfahren zur Herstellung eines Formteilnutzens mit einer Vielzahl von Formteilen herzustellen, wobei der Formteilnutzen eine gute Stabilität zur weiteren Handhabung besitzen soll.

Die Lösung dieser Aufgabe wird durch den kennzeichnenden Teil des Anspruches 1 wiedergegeben.

Der Erfindung liegt die Erkenntnis zugrunde, daß die geforderten miniaturisierten Formteile innerhalb eines Formteilnutzens nur durch ein Stanzverfahren herzustellen sind, das auf dem Prinzip des Negativstanzens beruht. Darunter ist eine Verfahrensweise zu verstehen, die bei zwei aufeinanderfolgenden Stanzvorgängen mit einem Stanzstempel einen vorgebbaren Teilungsvorschub anlegt, der genau der Summe aus Stempelbreite und Formteilbreite entspricht. Somit wird nicht ein der Stempelgeometrie entsprechendes Formteil herausgestanzt. Es wird vielmehr der stehengebliebene Reststeg verwendet, der bedingt durch die beiderseitigen Konturen des Stanzstempels die gewünschte Form erhält. Da als Ausgangsmaterial ein Metallband verwendet wird und die Länge des Stanzstempels kleiner ist, als die Breite des Metallbandes, bleibt am Rand ein Rahmen des Metallbandes erhalten, der dem Formteilnutzen seine Stabilität gibt.

Durch an bestimmten Stellen vorgebbares Einschieben von Leerhüben kann die Stabilität des Formteilnutzens durch die damit erzielten breiteren Reststege weiter vergrößert werden.

Eine besonders vorteilhafte Ausnutzung des Metallbandes ergibt sich durch die Ausgestaltung des Stanzstempels in der Form, daß innerhalb der gesamten Länge eines Formteiles mehrere Leiterbahnkonfigurationen, beispielsweise verschieden geformte Mäander, enthalten sind.

Zur Reparatur von Leiterbahnen in der Nähe von Anschlußaugen ist es vorteilhaft diese Anschlüsse an Anschlußaugen bereits im Formteilnutzen vorzusehen. Dies geschieht aus Stabilitätsgründen zweckmäßigerweise in der Form, daß diese Anschlüsse für Anschlußaugen die Enden des Formteils bilden, die am stabilen äußeren Rahmen des Formteilnutzens ansetzen.

Eine Ausführungsform einer Vorrichtung zur Durchführung des Verfahrens zur Herstellung von Formteilnutzen ist im Anspruch 5 wiedergegeben.

Die Auflage und Arretierung des Metallbandes zur Herstellung eines Formteilnutzens kann in einfach zu handhabender Weise durch Permanentmagnete in Kombination mit Hilfs- und Klemmplatten geschehen.

Zur einfachen Handhabung ist die Aufnahmeplatte zudem um eine zweckmäßigerweise senkrecht stehende Drehachse aus- und einschwenkbar.

Im folgenden wird anhand von schematischen Zeichnungen ein Ausführungsbeispiel der Erfindung wiedergegeben.

Figur 1 zeigt einen Ausschnitt aus einem Formteilnutzen 1 mit Formteilen 2,

Figur 2 zeigt eine Vorrichtung zur Durchführung des Verfahrens,

Figur 3 zeigt den Querschnitt durch eine Leiterbahn 7 und ein darüber positioniertes Formteil 2 und

Figur 4 zeigt eine besondere Ausgestaltung der Halterung des Metallbandes 14 innerhalb der Vorrichtung zur Durchführung des Verfahrens.

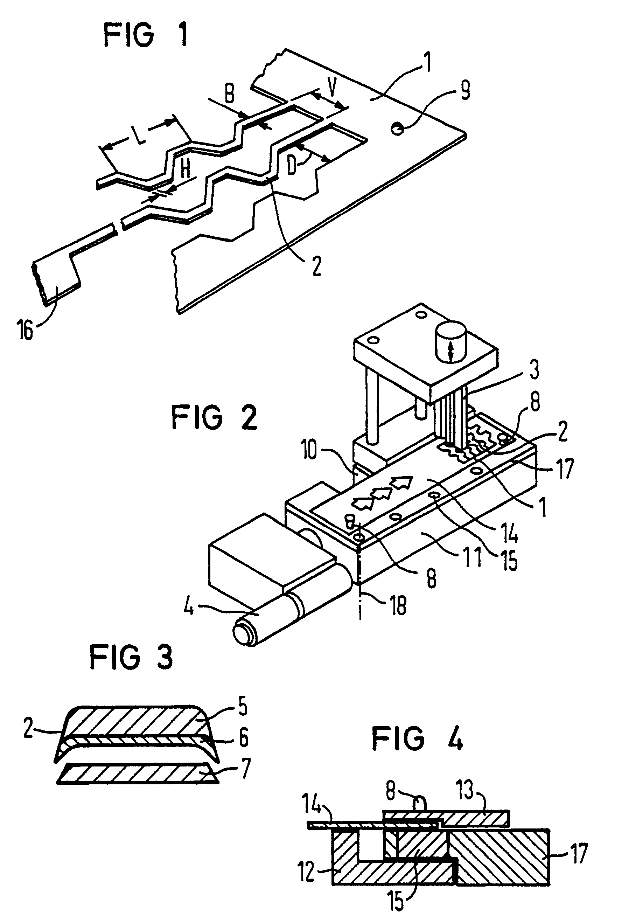

In der Figur 1 ist ein Ausschnitt aus einem Formteilnutzen 1 wiedergegeben, der mittels des erfindungsgemäßen Verfahrens und der entsprechenden Vorrichtung angefertigt wird. Dieser beinhaltet einen Teil des umlaufenden stabilen Rahmens, der Positionierlöcher 9 aufweist und eine Vielzahl von Formteilen 2 umgibt. Die während des Stanzverfahrens herausgestanzten Teile hinterlassen entsprechend der Stempelbreite D Bereiche, zwischen denen die Reststege als Formteile 2 erscheinen. Diese Formteile haben beispielsweise die Dimensionierung von : Breite B ca. 60 μm, Höhe H ca. 25 μm und einer Länge L einer Leiterbahnkonfiguration von 1,5 mm. Die Länge der Leiterbahnkonfiguration stellt in diesem Fall eine periodische Bildwiederkehr dar, wobei innerhalb einer Gesamtlänge eines Formteiles verschiedene Leiterbahnkonfigurationen auftauchen können. Die Stempelbreite D liegt beispielsweise bei 540 μm, woraus sich ein Vorschub V von 540 μm + 60 μm = 600 μm ergibt. In der Figur 1 ist andeutungsweise ein Anschluß für ein Anschlußauge 16 dargestellt, der zweckmäßigerweise am Übergang eines Reststeges zum umlaufenden Rahmen plaziert ist.

Mit dem Negativstanzverfahren, das Teile entsprechend der Stanzstempelbreite D herausnimmt und Reststege, die Formteile 2, übrig läßt, sind Reparaturteile mit einer Breite von den geforderten 50 bis 70 μm herstellbar. Die gesamte Stanzlänge der Formteile ist in diesem Fall auf 6,4 mm ausgelegt und ist abhängig von der periodischen Wiederkehr der Leiterbahnkonfigurationen. Die Schnittluft für einen gratfreien Schnitt bei einer 20 μm dicken Kupferfolie beträgt zwischen 0 und 2 μm. Die Stabilität eines Formteilnutzens ist einerseits durch den umlaufenden Rahmen gegeben und wird zusätzlich durch ein oder mehrere breite Reststege verstärkt. Derartige Reststege werden beispielsweise durch meist drei Leertakte nach 34 Arbeitstakten verwirklicht.

Die Figur 2 zeigt eine Vorrichtung zur Durchführung des erfindungsgemäßen Verfahrens. Auf eine Aufnahmeplatte 17 des Schlittens 11, der mittels eines Motors 4 angetrieben und getaktet wird ist ein Metallband 14 aufgelegt und durch Positionierstifte 8, die in Positionierlöcher 9 eingreifen, arretiert. Die Vorschubrichtung des Schlittens 11 mit dem Metallband 14 ist durch große Pfeile gekennzeichnet. Die Hubbewegungen des Stanzstempels 3 sind ebenfalls durch einen Doppelpfeil verdeutlicht. Der Stanzstempel 3 wirkt mit einer Schnittplatte 10 zusammen. Der für den Stanzvorgang zusätzlich notwendige Niederhalter zum Klemmen des Reststeges ist nicht gezeichnet. Durch die bereits beschriebene Abstimmung von Stempelbreite D und Vorschub V werden die Formteile 2 mit der entsprechenden Breite B in Form von Reststegen hergestellt. In der Figur 2 ist deutlich der umlaufende Rahmen des Formteilnutzens 1 zu erkennen, der dadurch entsteht, daß die Länge des Stanzstempels 3 kleiner ist, als die gesamte Breite des Metallbandes 14.

Die Figur 3 zeigt im Schnitt eine Leiterbahn 7, über die ein entsprechendes Formteil 2 zur Reparatur dargestellt ist. Das Formteil 2 besteht aus einem Träger, dem Metallband 5, und einer Hartlotplattierung 6. Die durch das Stanzen beidseitig entstehenden Grate sind in der Figur 3 angedeutet. Die Länge eines derartigen Formteils 2 sowie deren Auswahl innerhalb verschiedener Konfigurationen in einem Reststeg werden bezüglich der Weiterverarbeitung so gewählt, daß ein aus einem Formteilnutzen herausgetrenntes Formteil 2 deckungsgleich zur Leiterbahnkonfiguration und möglichst symmetrisch, für den Verbindungsvorgang beidseitig überlappend zur Leiterbahnunterbrechung vorliegt.

In der Figur 4 ist eine vorteilhafte Ausgestaltung der in Figur 2 gezeigten Vorrichtung zur Durchführung des erfindungsgemäßen Verfahrens dargestellt. Die durch Toleranzen zwischen Posiotonierlöchern 9 und Positionierstiften 8 immer gegebenen Fehler in der Arretierung eines Metallbandes 14 können bei gleichzeitiger Erleichterung der Handhabung durch den Einsatz von einer Hilfsplatte 12 und einer Klemmplatte 13 umgangen werden. Das Einlegen und die Arretierung des Metallbandes 14 auf den Schlitten 11 geschieht in der Form, daß zuerst die Hilfsplatte 12, eine Art Stützplatte, an entsprechender Ausformung des Schlittens 11 angebracht wird. Die Halterung geschieht durch einen oder mehrere im Schlitten 11 untergebrachte Dauermaonete und die entsprechend magnetische Ausführung der Hilfsplatte 12. Im Anschluß daran wird das Metallband 14 in die auf dem Schlitten 11 vorhandenen Positionierstifte 8 plaziert. Nachdem die Klemmplatte 13 aufgelegt und auf den Stift eingehängt ist, kann die Hilfsplatte 12 nach unten hin entfernt werden. Die Klemmplatte 13 wird ebenfalls durch die besagten im Schlitten 11 untergebrachten Dauermagneten gehalten.

Zum Einlegen des Metallbandes 14 in die Vorschubeinrichtung ist es zweckmäßig, die Aufnahmeplatte 17 auf dem Schlitten 11 über eine Drehachse schwenkbar auszulegen. Diese Drehachse steht senkrecht und ist zweckmäßigerweise außerhalb der Auflagefläche des Metallbandes 14, wie sie in Figur 2 angedeutet ist, plaziert.

Der Motor 4 ist als Schrittmotor ausgelegt. Die Schritte mit dem Vorschub V werden über eine Schrittmotorsteuerung vorgegeben.

**Ansprüche**

1. Verfahren zur Herstellung von Formteilnutzen (1) mit mindestens einem Formteil (2) zur Reparatur von Leiterbahnen (7), insbesondere zur Reparatur von mäanderförmigen Leiterbahnen mittels eines hartlotplattierten Formteiles (2), mit

  – mindestens zwei aufeinanderfolgenden Stanzvorgängen mit einem Stanzstempel (3),

– einem vorgebbaren Vorschub (V) zwischen einem Metallband (14) und dem Stanzstempel (3) zwischen dem zwei Stanzvorgängen, wobei die Länge des Vorschubes (V) größer ist als die Stempelbreite (D), die Länge des Stanzstempels (3) kleiner ist als die Breite des Metallbandes (14) und das Formteil (2) durch den Reststeg gebildet wird.

2. Verfahren nach Anspruch 1, **gekennzeichnet durch** eine vorgebbare Anzahl von mindestens einem zusätzlichen Vorschub (V) ohne Stanzvorgang zur Versteifung des Formteilnutzens (1) durch Ausbildung eines breiten Reststeges.

3. Verfahren nach einem der vorhergehenden Ansprüche, **dadurch gekennzeichnet, daß** innerhalb der Gesamtlänge eines Formteiles (2) mindestens eine Leiterbahnkonfiguration enthalten ist.

4. Verfahren nach einem der vorhergehenden Ansprüche, **dadurch gekennzeichnet, daß** die Enden eines Formteiles (2) innerhalb eines Formteilnutzens (1) als Anschlüsse (16) für Anschlußaugen ausgebildet sind.

5. Vorrichtung zur Durchführung des Verfahrens nach einem der vorhergehenden Ansprüche, **gekennzeichnet durch,**
– eine Aufnahmeplatte (17) auf einem Schlitten (11) zur Aufnahme eines Metallbandes (14),
– einen Stanzstempel (3) mit Niederhalter,
– einen Motor (4) zur Erzeugung eines vorgebbaren Vorschubes zwischen Stanzstempel (3) und Metallband (14)
– mindestens zwei Positionierstifte (8) zur Positionierung des Metallbandes (14) auf der Aufnahmeplatte (17),
– eine Schnittplatte (10), die mit dem senkrecht auf und ab bewegbaren Stanzstempel (3) und seinem Niederhalter zusammenwirkt.

6. Vorrichtung nach Anspruch 5, **gekennzeichnet durch,** eine an der Aufnahmeplatte (17) durch Permanentmagnete (15) gehaltene Klemmvorrichtung für das Metallband (14), bestehend aus :
– mindestens einer Hilfsplatte (12) zum Auflegen des Metallbandes (14) auf der Aufnahmeplatte (17),
– mindestens einer Klemmplatte (13) zum Arretieren des Metallbandes (14) auf der Aufnahmeplatte (17).

7. Vorrichtung nach Anspruch 5 oder 6, **dadurch gekennzeichnet, daß** die Aufnahmeplatte (17) auf dem Schlitten (11) für den Einlegevorgang des Metallbandes (14) über eine Drehachse (18) schwenkbar ist.

## Claims

1. Method of producing preform panels (1) with at least one preform (2) for the purpose of repairing printed conductors (7), preferably for repairing meandering printed conductors by means of a hard-solder plated preform (2), comprising
– at least two consecutive punching processes using a punch (3),
– a predeterminable feed (V) between a metal strip (14) and the punch (3) between the two punching processes, the length of the feed (3) being greater than the punch width (D), the length of the punch (3) being smaller than the width of the metal strip (14), and the preform (2) being formed by the residual web.

2. Method according to Claim 1, characterised by a predeterminable number of at least one additional feed (V) without a punching process for the purpose of stiffening the preform panel (1) by forming a wide residual web.

3. Method according to one of the preceding claims, characterised in that at least one printed conductor configuration is contained within the total length of a preform (2).

4. Method according to one of the preceding claims, characterised in that the ends of a preform (2) are formed inside a preform panel (1) as terminals (16) for terminal pads.

5. Apparatus for carrying out the method according to one of the preceding claims, characterised by
– a receiver plate (17) on a slide (11) for receiving a metal strip (14),
– a punch (3) with a holding-down clamp,
– a motor (4) for generating a predeterminable feed between the punch (3) and metal strip (14),
– at least two positioning pins (8) for positioning the metal strip (14) on the receiver plate (17),
– a cutting plate (10), which cooperates with the punch (3), which can be moved up and down vertically, and its holding-down clamp.

6. Apparatus according to Claim 5, characterised by a clamping device for the metal strip (14), which is held on the receiver plate (17) by permanent magnets (15) and consists of :
– at least one auxiliary plate (12) for laying the metal strip (14) onto the receiver plate (17),
– at least one clamping plate (13) for locating the metal strip (14) in position on the receiver plate (17).

7. Apparatus according to Claim 5 or 6, characterised in that for the purpose of inserting the metal strip (14) the receiver plate (17) can be swivelled on the slide (11) via an axis of rotation (18).

## Revendications

1. Procédé pour la fabrication de flans conformés (1) avec au moins un élément conformé (2), pour la réparation de pistes conductrices (7), en particulier pour la réparation de pistes conductrices en forme de méandres à l'aide d'un élément conformé (2) plaqué d'un métal d'apport de brasage fort, avec

    – au moins deux opérations d'estampage successives avec un poinçon d'estampage (3),

    – une avance prédéterminée (V) entre une bande métallique (14) et le poinçon (3), entre les deux opérations d'estampage, la longueur de l'avance (V) étant supérieure à la largeur (D) du poinçon, la longueur du poinçon (3) étant inférieure à la largeur de la bande métallique (14), et l'élément conformé (2) étant formé par la barrette résiduelle.

2. Procédé selon la revendication 1, caractérisé par un nombre prédéterminé d'au moins une avance supplémentaire (V) sans opération d'estampage, en vue de rigidifier le flan conformé (1) par la formation d'une large barrette résiduelle.

3. Procédé selon l'une des revendications précédentes, caractérisé par le fait qu'à l'intérieur de la longueur totale d'un élément conformé est contenue au moins une configuration de piste conductrice.

4. Procédé selon l'une des revendications précédentes, caractérisé par le fait que les extrémités d'un élément conformé (2) sont réalisées à l'intérieur d'un flan conformé (1) pour constituer des bornes de branchement (16) pour des oeillets de branchement.

5. Dispositif pour la mise en oeuvre du procédé selon l'une des revendications précédentes, caractérisé par

    – une plaque de réception (17) sur un chariot (11) pour recevoir une bande métallique (14),

    – un poinçon d'estampage (3), avec des serre-flans,

    – un moteur (4) pour produire un mouvement d'avancée prédéterminé entre le poinçon d'estampage (3) et la bande métallique (14),

    – au moins deux chevilles de positionnement (8) pour positionner le ruban métallique (14) sur la plaque de réception (17),

    – une plaque de découpage (10) qui coagit avec le poinçon d'estampage déplaçable verticalement dans un sens et dans l'autre et avec son serre-flan.

6. Dispositif selon la revendication 5, caractérisé par un dispositif de serrage pour le ruban métallique (14), maintenu sur la plaque de réception par des aimants permanents (15), lequel dispositif de serrage est constitué par :

    – au moins une plaque auxiliaire (12) pour la mise en place de la bande métallique (14) sur la plaque de réception (17),

    – au moins une plaque de serrage (13) pour bloquer le ruban métallique (14) sur la plaque de réception (17).

7. Dispositif selon la revendication 5 ou 6, caractérisé par le fait que la plaque de réception (17) est articulée à l'aide d'un axe de rotation (18) sur le chariot (11), pour l'opération d'introduction de la bande métallique (14).

FIG 1

FIG 2

FIG 3

FIG 4